# EUROPÄISCHE PATENTSCHRIFT

(11) **EP 3 582 304 B1**
(45) Veröffentlichungstag und Bekanntmachung des Hinweises auf die Patenterteilung: **08.12.2021**
(21) Anmeldenummer: 19179653.1
(22) Anmeldetag: 12.06.2019
(51) Int. Cl.: H01M 4/36, H01M 4/38, H01M 4/62

(54) **AKTIVMATERIALKÖRPER FÜR EINEN AKKUMULATOR**
ACTIVE MATERIAL BODY FOR A BATTERY
CORPS DE MATIÈRE ACTIVE POUR UN ACCUMULATEUR

(30) Priorität: 12.06.2018 DE 102018114009
(43) Veröffentlichungstag der Anmeldung: 18.12.2019
(73) Patentinhaber: Volkswagen AG, 38440 Wolfsburg (DE)
(72) Erfinder: Schladt, Thomas, 38126 Braunschweig (DE); Graf, Tanja, 38126 Braunschweig (DE)
(74) Vertreter: Rössler, Matthias

(56) Entgegenhaltungen:
- WO-A1-2013/183848
- US-A1- 2018 159 182

## Beschreibung

Die Erfindung betrifft einen Aktivmaterialkörper für einen Akkumulator.

Aktivmaterialkörper bilden regelmäßig Elektroden in einem Akkumulator. Ein Akkumulator ist ein wiederaufladbarer Speicher für elektrische Energie auf elektrochemischer Basis. Es sind z. B. Lithium-Ionen Akkumulatoren bekannt, wobei die reaktiven Materialien (Aktivmaterialien) sowohl in der negativen als auch in der positiven Elektrode sowie der Elektrolyt Lithiumionen enthalten.

Bei Lithium-Ionen-Akkumulatoren kommt es über die Lebensdauer zu Kapazitäts- und Perfomance-Verlusten, die auf eine Degeneration der Elektroden zurückzuführen sind. Ein wichtiger Effekt sind hierbei (elektro-)chemische Reaktionen zwischen Aktivmaterial und Elektrolyt an der Oberfläche des Aktivmaterials. Hierbei kommt es zur Zersetzung der Elektrolyten und es entsteht eine dünne Schicht auf der Oberfläche des Aktivmaterials, die sogenannten SEI *(Solid Electrolyte Interphase).* Die SEI besteht zu großen Teilen aus amorphen bzw. teilkristallinen Lithium-haltigen Verbindungen, die aus elektrochemischer Sicht inert sind, d. h. die Lithiumionen können nicht mehr an den elektrochemischen Prozessen in der Akkumulatorzelle teilnehmen, was letztendlich eine Abnahme der Zellkapazität zur Folge hat. Daneben haben die Reaktionen an der Oberfläche auch negative Folgen auf das Aktivmaterial selbst. Beim Kathodenmaterial kann es zu Strukturumwandlung an der Oberfläche und in oberflächennahen Schichten kommen. Dabei wird die für Nickel-Mangan-Kobalt-(NMC)-basierte Kathodenmaterialien typische Schichtstruktur (Raumgruppe R-3m) in eine Spinellstruktur (Raumgruppe Fd-3m) oder sogar in eine Kochsalzstruktur (Raumgruppe Fm-3m) umgewandelt. Dies führt neben dem Verlust an Kapazität auch zu einem Anstieg des Innenwiderstandes, was auf eine erschwerte Diffusion der Lithiumionen durch Spinell- und Kochsalzstruktur zurückzuführen ist. Darüber hinaus sind solche Umwandlungen mit erheblichen mechanischen Spannungen verbunden, was die mechanische Integrität des Materials deutlich herabsetzt bis hin zur Fragmentierung bzw. Pulverisierung.

Eine weitere Problematik stellt außerdem die Herauslösung von Übergangsmetallkationen (vor allem Mangan) aus der Oberfläche des Aktivmaterials dar. Dies wird vor allem durch Fluorkohlenwasserstoff (HF) verursacht, welcher sich wiederum bei der Zersetzung der im Elektrolyten befindlichen Leitsalze (z. B. LiPF₆) in Gegenwart von Wasser bildet.

Ein weiterer Aspekt, der für Degradation der Aktivmaterialien im Betrieb der Zelle relevant ist, ist die Änderung der Gitterparameter der Aktivmaterialien beim Laden und Entladen. Es ist aus experimentellen und theoretischen Untersuchungen bekannt, dass sich z. B. das Kristallgitter von NMC-Kathodenmaterialien während des Ladens/Entladens um bis zu 10% anisotrop verändern kann. Diese Volumenveränderung führt nicht nur zu intensiven mechanischen Spannungen innerhalb der Primärpartikel, sondern letztlich auch in den daraus aufgebauten Sekundärpartikeln. Durch diese mechanischen Spannungen entstehen Risse zwischen den Primärpartikeln, die schließlich bis zum Zerbrechen der Sekundärpartikel führen. Dadurch kommt es zu ausgeprägten Alterungserscheinungen, wie z. B. Kapazitätsverlust. Zudem entstehen durch das Zerbrechen der Partikel frische Oberflächen, die erneut mit dem Elektrolyten reagieren können und somit weiter zum Performanceverlust der Zelle beitragen.

Es sind verschiedene Ansätze bekannt, die sowohl die unerwünschten (elektro-)chemischen Reaktionen an der Oberfläche des Aktivmaterials als auch die Alterungserscheinungen adressieren. Zum einen können dem Elektrolyten spezielle Additive zugesetzt werden, die die unerwünschten Reaktionen mit dem Elektrolyten an der Oberfläche verringern oder Reaktionsprodukte abfangen. Ein weiterer Ansatz ist die nass-/trockenchemische Beschichtung der Partikel oder Elektroden mit einem inerten Material. Beschichtungen mit Aluminiumoxid werden von verschiedenen Anbietern entwickelt und gegenwärtig erprobt. Außerdem gibt es Ansätze, Beschichtungsmaterialien auf Basis von Phosphaten und Oxiden zu entwickeln, die die Reaktion mit dem Elektrolyten an der Partikeloberfläche unterdrücken, aber gleichzeitig die Diffusion von Lithiumionen erlauben.

Der Zusatz von Additiven verringert einerseits das Ausmaß der Grenzflächenreaktivität zwischen Elektrolyt und Aktivmaterial, kann diese aber andererseits nicht vollständig verhindern und fügt dem System darüber hinaus ein zusätzliches Maß an Komplexität zu.

Gängige Beschichtungskonzepte, wie z. B. die nass-/trockenchemische Beschichtung mit Aluminiumoxid (Al₂O₃) führen einerseits zu einer mehr oder weniger dichten Bedeckung der Oberfläche des Aktivmaterials und damit zu einem gewissen Schutz vor unerwünschten Reaktionen, aufgrund des elektrochemisch inerten Charakters von Al₂O₃ geht dies andererseits aber mit deutlichen Einbußen in der Zell-Performance einher. Dies ist vor allem dann der Fall, wenn die Beschichtung elektrisch schlecht leitfähig ist (wie im Fall von Al₂O₃) und somit den elektrischen Widerstand zwischen den Partikeln vergrößert. Ein weiterer negativer Aspekt ist die überaus schlechte Leitfähigkeit für Lithiumionen, was ebenfalls zu einem erhöhten Innenwiderstand sowie einer Limitierung der Ladefähigkeit führt.

Diese beiden Aspekte, d. h. elektrischer Widerstand und schlechte Lithiumionenleitfähigkeit, sind umso schlimmer, je dicker die Beschichtung auf das Aktivmaterial aufgebracht ist. Leider sind gängige Beschichtungsverfahren nicht in der Lage, eine ausreichend dünne, konforme und dichte Schicht auf den Aktivmaterialien zu garantieren.

Aus der US 8,080,337 B2 ist ein Lithiumionen-Akkumulator bekannt, bei dem die Elektroden durch ein beschichtetes Aktivmaterial gebildet sind. Ein als Beschichtung des Aktivmaterials vorgesehenes Material weist dabei ein höheres Elastizitätsmodul als das Aktivmaterial auf.

Bisher wurden diese Probleme z. B. dadurch umgangen, dass durch ein Akkumulatormanagement-System versucht wurde, kritische Lastpunkte beim Betrieb zu vermeiden. Schnellladevorgänge werden dabei vermieden oder deren Geschwindigkeit so weit wie möglich verringert, da diese sonst zu einer deutlichen Verkürzung der Akkumulator-Lebensdauer führen können.

Die WO 2013/183848 A1 offenbart ein Aktivmaterial mit einer Beschichtung aus DLC. Die äußere Schicht weist einen besonders hohen Elastizitätsmodul auf, so dass eine Volumenausdehnung des Aktivmaterials durch die DLC-Beschichtung verhindert wird.

Die US 2018/01589182 A1 offenbart ein Aktivmaterial mit einer Beschichtung. Die Beschichtung umfasst z. B. SiO₂.

Aufgabe der vorliegenden Erfindung ist es, die mit Bezug auf den Stand der Technik angeführten Probleme zumindest teilweise zu lösen. Insbesondere soll ein Aktivmaterialkörper vorgeschlagen werden, mit dem ein langlebiger Akkumulator herstellbar ist, der insbesondere für Schnellladevorgänge geeignet ausgeführt ist.

Zur Lösung dieser Aufgaben trägt ein Aktivmaterialkörper mit den Merkmalen gemäß Patentanspruch 1 bei. Vorteilhafte Weiterbildungen sind Gegenstand der abhängigen Patentansprüche. Die in den Patentansprüchen einzeln aufgeführten Merkmale sind in technologisch sinnvoller Weise miteinander kombinierbar und können durch erläuternde Sachverhalte aus der Beschreibung und/oder Details aus den Figuren ergänzt werden, wobei weitere Ausführungsvarianten der Erfindung aufgezeigt werden.

Es wird ein Aktivmaterialkörper für einen Akkumulator vorgeschlagen. Der Aktivmaterialkörper umfasst zumindest ein Aktivmaterial, das einen Aktivmaterial-Elastizitätsmodul E_{A} aufweist, und mindestens eine an der Oberfläche des Aktivmaterials angeordnete schichtförmige erste Beschichtung. Die erste Beschichtung besteht aus einem ersten Material mit einem ersten Elastizitätsmodul E₁; wobei gilt: erstes Elastizitätsmodul ≤ Aktivmaterial-Elastizitätsmodul (also erstes Elastizitätsmodul ist kleiner oder höchstens so groß wie das Aktivmaterial-Elastizitätsmodul).

Es ist beobachtet worden, dass eine Beschichtung des Aktivmaterials durch ein Material mit höherem Elastizitätsmodul ein sogenannter "Eierschalen-Effekt" auftreten kann. Dieser tritt insbesondere bei den gängigen Materialien, die für Beschichtungen der Aktivmaterialen eingesetzt werden, auf. Z. B. liegt der Elastizitätsmodul von Aluminiumoxid, je nach Reinheit, zwischen 300 und 400 GPa [GigaPascal]. Der Elastizitätsmodul der meisten Aktivmaterialien auf der Kathodenseite, wie z. B. NMC-Materialien, beträgt zwischen 100 und 200 GPa. Bei dieser Kombination einer Beschichtung mit hohem Elastizitätsmodul und einem Aktivmaterial mit geringerem Elastizitätsmodul kann es bereits unter moderater mechanischer Belastung zur Rissbildung und zu einem Abplatzen der Beschichtung kommen. Darüber hinaus kann das Problem der Partikel-Fragmentierung bzw. der Rissbildung durch diese spröden Beschichtungen nicht verhindert werden. Die Beschichtung platzt unter der mechanischen Last, sei sie durch äußere mechanische Einflüsse oder durch die ladungsbedingte Volumenänderung der Primärpartikel hervorgerufen, ab, wodurch Beschichtungseigenschaften verloren gehen.

Vorliegend wird demgegenüber vorgeschlagen, das Aktivmaterial zumindest mit einer ersten Beschichtung zu versehen, die einen geringeren Elastizitätsmodul als das Aktivmaterial aufweist.

Insbesondere ist der Elastizitätsmodul E₁ mindestens 10 %, insbesondere mindestens 20 %, geringer als der Elastizitätsmodul E_{A}.

Bevorzugt weist zumindest die erste Beschichtung eine erste Dicke von höchstens 2 Nanometern, bevorzugt von höchstens 1 Nanometer, auf.

Die Dicke wird insbesondere entlang der kürzesten Entfernung von der Oberfläche des Aktivmaterials zu der Oberfläche der ersten Beschichtung gemessen.

Insbesondere ist zumindest das erste Material eine anorganische Keramik.

Insbesondere wird für das erste Material ein Beschichtungsmaterial gewählt, dessen physikalisch-chemischen Materialeigenschaften einen Schutz in Form einer physikalischen Barriere bieten. Weiterhin sollte der Elastizitätsmodul E₁, kleiner oder höchstens gleich dem Aktivmaterial-Elastizitätsmodul E_{A} sein. Als erste Materialien sind insbesondere anorganische keramischen Verbindungen vorgesehen, die sich durch hohe thermodynamische Stabilität (d. h. deutlich negative freie Bildungsenthalpie) auszeichnen. Aufgrund der geringen Leitfähigkeit vieler anorganischer keramischer Verbindungen sollte die Dicke der ersten Beschichtung nur im unteren Nanometerbereich liegen.

Erfindungsgemäß umfasst der Aktivmaterialkörper mindestens eine an der Oberfläche einer n-1-ten Beschichtung angeordnete n-te Beschichtung, wobei die n-te Beschichtung aus einem n-ten Material mit einem n-ten Elastizitätsmodul Eₙ besteht, wobei n = 2, 3, 4, ...; wobei gilt: n-tes Elastizitätsmodul ≤ n-1-tes Elastizitätsmodul ≤ Aktivmaterial-Elastizitätsmodul.

Insbesondere wird vorgeschlagen, dass der Aktivmaterialkörper eine multifunktionale Beschichtung aufweist, die aus mehreren Komponenten besteht, wobei jede Komponente gezielt auf die Anforderungen des Aktivmaterials und denen der Umgebung (insbesondere Elektrolyt) angepasst ist. Diese Anforderungen zeichnen sich insbesondere durch (elektro-)chemische bzw. physikalische und bevorzugt alternativ oder zusätzlich durch eine mechanische Kompatibilität aus.

Insbesondere dient die erste Beschichtung als physikalische Barriere, d. h. sie soll thermodynamische und strukturelle Stabilität (d. h. Aufrechterhaltung der Schichtstruktur im Aktivmaterial) und ggf. zusätzlich mechanische Integrität gewährleisten. Insbesondere erfolgt dies durch die Anpassung der mechanischen Eigenschaften (wie z. B. Elastizitätsmodul, Querkontraktionszahl, Schubmodul, Kompressionsmodul) an das Aktivmaterial. Aus (elektro-)chemischer bzw. physikalischer Sicht verfügt die erste Beschichtung insbesondere (zusätzlich) über eine gute elektrische bzw. Lithiumionen-Leitfähigkeit.

Insbesondere weisen zumindest zwei zueinander benachbart angeordnete Beschichtungen Elastizitätsmodule auf, die sich um mindestens 10 GPa [GigaPascal] und/oder mindestens 10 % hinsichtlich des Elastizitätsmoduls (n-ter ist mindestens 10 % kleiner als n-1ter) unterscheiden.

Insbesondere umfasst zumindest ein n-tes Material, mit n = 2, 3, 4,..., ein rein organisches Material oder ein anorganisches-organisches Hybridmaterial. Insbesondere dient eine zweite Beschichtung als chemische Barriere (gegen Elektrolyt, Fluorwasserstoff, etc.). Aus (elektro-)chemischer bzw. physikalischer Sicht verfügt die zweite Beschichtung insbesondere (zusätzlich) über eine gute elektrische bzw. Lithiumionen-Leitfähigkeit.

Das n-te Material, mit n = 2, 3, 4,..., umfasst insbesondere rein organische Verbindungen, z. B. verschiedene Polymere, oder auch anorganisch-organische Hybridpolymere, wie z. B. Alucone.

Insbesondere weist eine n-te Beschichtung eine n-te Dicke auf, mit n = 2, 3, 4,..., wobei zumindest eine der n-ten Dicken mindestens so groß ist wie eine erste Dicke der ersten Beschichtung.

Insbesondere ist keine der n-ten Dicken, mit n = 2, 3, 4,..., dicker als 5 Nanometer.

Die Dicke der n-ten Beschichtung kann größer sein als die erste Beschichtung, da die organischen bzw. anorganisch-organischen Hybridmaterialien eine bessere Lithiumionen-Leitfähigkeiten aufweisen.

Insbesondere werden die Eigenschaften der n-ten Beschichtung gegenüber der ersten Beschichtung so eingestellt, dass mit jeder weiter außen angeordneten Beschichtung die mechanischen Eigenschaften hin zu weniger Sprödigkeit, geringerem Elastizitätsmodul, geringerem Schubmodul, geringerem Kompressionsmodul eingestellt werden.

Zumindest die erste Beschichtung kann durch ein chemisches Gasabscheidungsverfahren auf der Oberfläche des Aktivmaterials appliziert sein.

Insbesondere werden Beschichtungsverfahren bevorzugt, durch die eine genaue Kontrolle der resultierenden Materialeigenschaften jeder Beschichtung ermöglicht werden kann. Darüber hinaus sind Beschichtungsverfahren bevorzugt, die ein hohes Maß an Kontrolle für die jeweilige Schichtdicke erlauben. Da die jeweiligen Schichtdicken nur im Bereich weniger Nanometer (insbesondere 1 bis 5 Nanometer) liegen sollten, sind chemische Gasabscheidungsverfahren, wie z. B. die Atomlagenabscheidung (ALD) und/oder Moleküllagenabscheidung (MLD) zu bevorzugen.

Insbesondere enthält das Aktivmaterial Lithiumionen.

Es wird weiter ein Akkumulator (eine Batterie) vorgeschlagen, zumindest aufweisend eine negativ gepolte erste Elektrode, eine positiv gepolte zweite Elektrode und ein die erste Elektrode und die zweite Elektrode (elektrisch nicht-leitend aber (Lithium-)lonen leitend) verbindendes Elektrolyt, wobei zumindest eine der Elektroden den beschriebenen Aktivmaterialkörper umfasst.

Die Ausführungen zu dem Akkumulator gelten gleichermaßen für das Aktivmaterial und umgekehrt.

Neben dem reinen Schutz der Oberfläche des Aktivmaterials werden vorliegend auch weitere intrinsische Eigenschaften der Materialien der Beschichtungen beschrieben, die während des Betriebs des Akkumulators relevant sind. Vor allem die Gewährleistung mechanischer Integrität bei wiederholten Lade-/Entladezyklen ist ein wesentliches Merkmal der hier beschriebenen (multifunktionalen) Beschichtung.

Des Weiteren bietet die Verwendung eines Mehrschichtsystems, bei dem Elastizitätsmoduln (ausgehend vom Aktivmaterial und über die einzelnen Beschichtungen) nach außen zunehmend kleiner werden, den Vorteil, dass Beschädigungen der inneren Schichten (hervorgerufen z. B. durch Volumenänderung des Substrats bzw. des Aktivmaterials) nicht nach außen propagieren können. D. h. selbst bei einem (teilweisen) Versagen der inneren Beschichtungen bleibt die mechanische Integrität des Gesamtsystems (Aktivmaterialkörper) erhalten.

Weiter können durch die Anwesenheit einer weicheren äußeren Schicht mechanische Lasten, wie sie z. B. bei der Fertigung des Akkumulators selbst auftreten, besser absorbiert werden, so dass in den Aktivmaterial nahen Beschichtungen und z. B. im Aktivmaterial selbst geringere Spannungen auftreten.

Die Simulation einer Van-Mises-Spannung in dem Aktivmaterialkörper mit mehreren Beschichtungen hat gezeigt, dass die Spannung im Aktivmaterial durch die Anwesenheit mehrerer Beschichtungen deutlich abnimmt. Weiter kann das Beschichtungssystem die Volumenänderung des Aktivmaterials abpuffern (durch die graduelle Änderung der mechanischen Eigenschaften). Damit kann ggf. eine Rissbildung nicht verhindert werden. Allerdings kann eine Risspropagation und daraus resultierende Fragmentierung verhindert werden, so dass die Partikel durch die Beschichtung(en) zusammengehalten werden.

Durch die Anordnung einer oder mehrerer Beschichtungen auf dem Aktivmaterial, bei denen sowohl die (elektro-)chemischen als auch die mechanischen Eigenschaften auf die Anforderungen des Aktivmaterials als auch auf die chemische Umgebung des Akkumulators angepasst sind, werden die Nachteile der eingangs beschriebenen Aktivmaterialien und Akkumulatoren behoben. Die schlechte elektrische und Lithiumionen-Leitfähigkeit von Aluminiumoxid wird durch geeignete andere Materialien mit höherer Leitfähigkeit verbessert. Die Verwendung von keramischen Materialien für die erste Beschichtung gewährleistet einen ausreichenden physikalischen und chemischen Schutz vor unerwünschten Oberflächenreaktionen mit dem Elektrolyten. Die Anpassung der mechanischen Eigenschaften (Elastizitätsmodul, Schubmodul, Kompressionsmodul, Querkontraktionszahl) der ersten Beschichtung an das darunterliegende Aktivmaterial erhöht durch die Stabilisierung des Kristallgitters die mechanische Integrität. Außerdem erlaubt die mechanische Flexibilität der n-ten Beschichtung, mit n = 2, 3, 4, ..., eine größere Volumenänderung beim Laden/Entladen und verhindert somit eine Fragmentierung oder gar Pulverisierung der Sekundärpartikel.

Die bisher bekannten Lösungen umfassen nass- oder trockenchemische Beschichtungsverfahren, bei denen die resultierenden Beschichtungen eine hohe und unregelmäßige Dicke der Beschichtung sowie eine geringere Dichtigkeit (sogenannte "pin-holes") aufweisen. Ersteres hat einen deutlich negativen Einfluss auf die Leitfähigkeit, während letzteres zu lokalen Reaktionszentren auf der Oberfläche führt, wo es zu umso stärkeren Reaktionen mit dem Elektrolyten kommen kann.

Durch die Anwendung von Beschichtungsverfahren mit einem hohen Maß an Prozesskontrolle und Beschichtungskonformität (wie z. B. dem ALD-Verfahren) kann sowohl eine sehr dünne Schichtdicke als auch eine hohe Dichtigkeit für jede einzelne Komponente erreicht werden.

Der vorgeschlagene Aktivmaterialkörper bzw. der Akkumulator kann insbesondere in Kraftfahrzeugen (PKW, Bus, LKW) mit Lithium-Ionen Akkumulatoren bzw. elektrischen Antrieben oder mit Brennstoffzellenantrieb, eingesetzt werden. Alternativ kann eine Verwendung für andere mobile Anwendungen (Elektrofahrräder) oder Consumer Electronics oder stationäre Anwendung vorgesehen sein.

Als bevorzugte Ausgestaltung wird ein Aktivmaterialkörper vorgeschlagen, der zumindest zwei Beschichtungen aufweist. Z. B. umfasst das Aktivmaterial NMC 111, die erste Beschichtung LiF, die zweite Beschichtung ein Polymer. Die Elastizitätsmodule sind wie folgt: E_{A} = 120 GPa; E₁ = 81 GPa, E₂ = 20 GPa.

Vorsorglich sei angemerkt, dass die hier verwendeten Zahlwörter ("erste", "zweite", ...) vorrangig (nur) zur Unterscheidung von mehreren gleichartigen Gegenständen, Größen oder Prozessen dienen, also insbesondere keine Abhängigkeit und/oder Reihenfolge dieser Gegenstände, Größen oder Prozesse zueinander zwingend vorgeben. Sollte eine Abhängigkeit und/oder Reihenfolge erforderlich sein, ist dies hier explizit angegeben oder es ergibt sich offensichtlich für den Fachmann beim Studium der konkret beschriebenen Ausgestaltung.

Die Erfindung sowie das technische Umfeld werden nachfolgend anhand der beiliegenden Figuren näher erläutert. Es ist darauf hinzuweisen, dass die Erfindung durch die angeführten Ausführungsbeispiele nicht beschränkt werden soll. Insbesondere ist es, soweit nicht explizit anders dargestellt, auch möglich, Teilaspekte der in den Figuren erläuterten Sachverhalte zu extrahieren und mit anderen Bestandteilen und Erkenntnissen aus der vorliegenden Beschreibung zu kombinieren. Insbesondere ist darauf hinzuweisen, dass die Figuren und insbesondere die dargestellten Größenverhältnisse nur schematisch sind. Es zeigen:
- Fig. 1:: ein Aktivmaterialkörper;
- Fig. 2:: eine erste Ausführungsvariante eines Aktivmaterialkörpers;
- Fig. 3:: eine zweite Ausführungsvariante eines Aktivmaterialkörpers;
- Fig. 4:: eine dritte Ausführungsvariante eines Aktivmaterialkörpers;
- Fig. 5:: ein Diagramm, mit den möglichen Variationen der Elastizitätsmodule der einzelnen Beschichtungen für den Aktivmaterialkörper nach Fig. 3;
- Fig. 6:: ein Diagramm, mit den möglichen Variationen der Elastizitätsmodule der einzelnen Beschichtungen für den Aktivmaterialkörper nach Fig. 4;
- Fig. 7: ein Schichtversagen bei Volumenänderung des Aktivmaterials;
- Fig. 8:: eine Rissausbreitung bei dem Aktivmaterialköper nach Fig. 3;
- Fig. 9:: eine Gegenüberstellung der Aktivmaterialkörper gemäß Fig. 7 und 8;
- Fig. 10:: eine Schädigung des Aktivmaterialkörpers bei Aufbringung einer äußeren mechanischen Last;
- Fig. 11:: eine Schädigung des Aktivmaterialkörpers nach Fig. 2 bei Aufbringung einer äußeren mechanischen Last;
- Fig. 12:: eine Schädigung des Aktivmaterialkörpers nach Fig. 3 bei Aufbringung einer äußeren mechanischen Last;
- Fig. 13:: eine Simulation einer mechanischen Belastung eines Aktivmaterials (ohne Beschichtung);
- Fig. 14:: eine Simulation einer mechanischen Belastung eines Aktivmaterialkörpers nach Fig. 2;
- Fig. 15:: eine Simulation einer mechanischen Belastung eines Aktivmaterialkörpers nach Fig. 3; und
- Fig. 16:: einen Akkumulator.

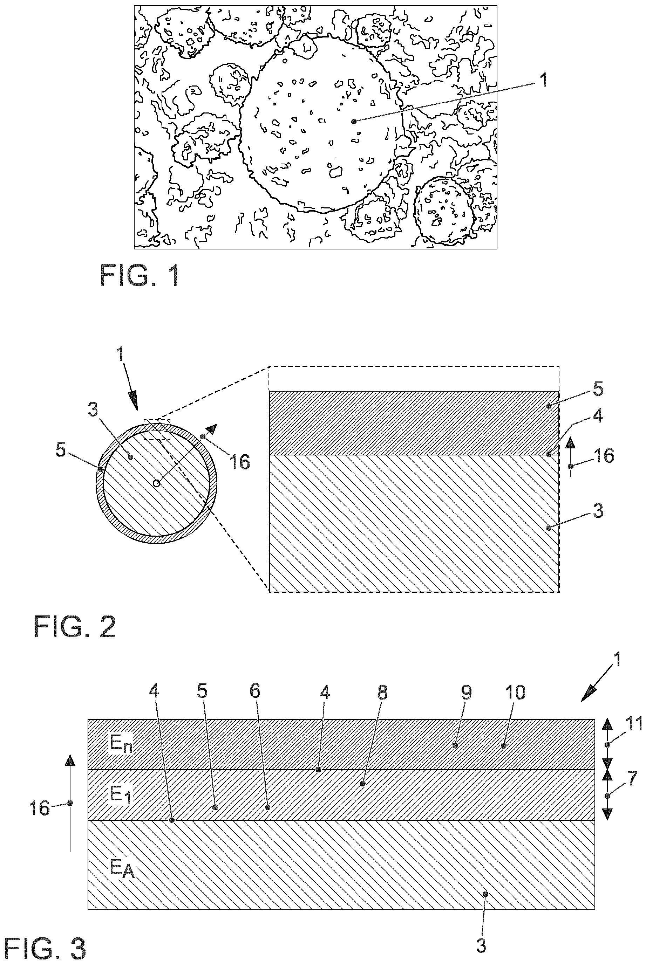

Fig. 1 zeigt ein Aktivmaterialkörper 1 (hier Kathodenmaterial) in einer Raster-Elektronen-Mikroskop (REM) Aufnahme.

Fig. 2 zeigt eine erste Ausführungsvariante eines Aktivmaterialkörpers 1 mit einem Aktivmaterial 3 und einer ersten Beschichtung 5 an der Oberfläche 4 des Aktivmaterials 3. Die erste Beschichtung 5 ist in der radialen Richtung 16 außerhalb von dem (kugeligen) Aktivmaterial 3 angeordnet.

Fig. 3 zeigt eine zweite Ausführungsvariante eines Aktivmaterialkörpers 1. Auf die Ausführungen zu Fig. 2 wird verwiesen.

Der vorliegende Aktivmaterialkörper 1 weist eine erste Beschichtung 5, 8 mit einer erste Dicke 7 und eine zweite Beschichtung 9 mit einer zweiten Dicke 11 auf. Die erste Beschichtung 5, 8 umfasst ein erstes Material 6, die zweite Beschichtung 9 eine zweite Dicke 11. Ausgehend von dem Aktivmaterial 3 verringert sich mit jeder Beschichtung 5, 8, 9 der Elastizitätsmodul E_{A}, E₁, E₂.

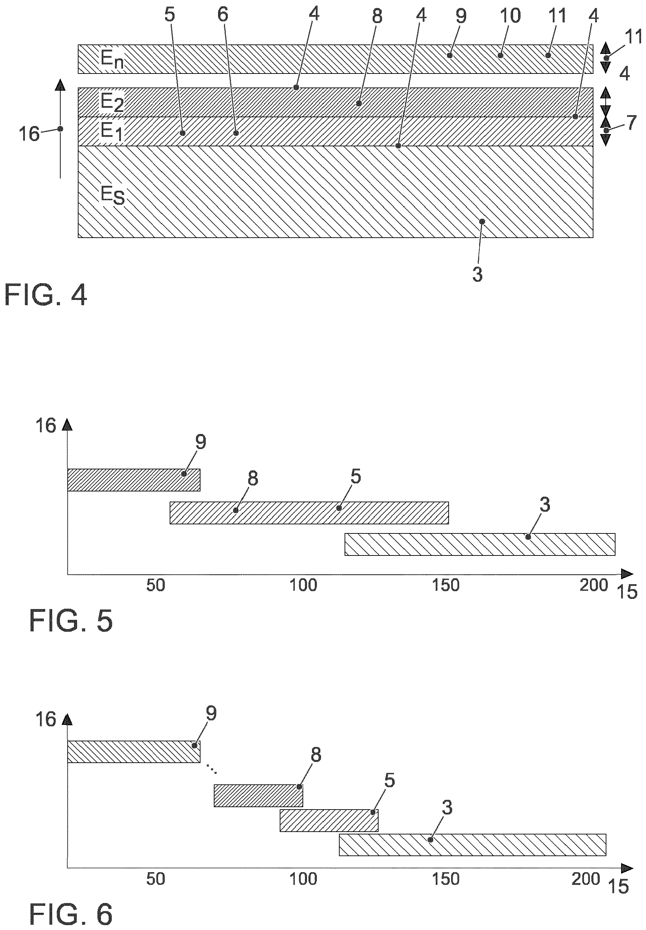

Fig. 4 zeigt eine dritte Ausführungsvariante eines Aktivmaterialkörpers 1. Auf die Ausführungen zu Fig. 3 wird verwiesen.

Im Unterschied zur zweiten Ausführungsvariante weist der vorliegende Aktivmaterialkörper 1 eine zusätzliche n-te (dritte) Beschichtung 9 aus einem n-ten Material 10, aufweisend eine n-te Dicke 11, auf.

Fig. 5 zeigt ein Diagramm, mit den möglichen Variationen der Elastizitätsmoduln der einzelnen Beschichtungen 5, 8, 9 (und des Aktivmaterials 3) für den Aktivmaterialkörper 1 nach Fig. 3. Auf die Ausführungen zu Fig. 3 wird verwiesen.

Auf der vertikalen Achse ist die radiale Richtung 16 aufgetragen. Auf der horizontalen Achse der Elastizitätsmodul 15.

Fig. 6. zeigt ein Diagramm, mit den möglichen Variationen der Elastizitätsmodule der einzelnen Beschichtungen 5, 8, 9 (und des Aktivmaterials 3) für den Aktivmaterialkörper 1 nach Fig. 4. Auf die Ausführungen zu Fig. 4 und 5 wird verwiesen.

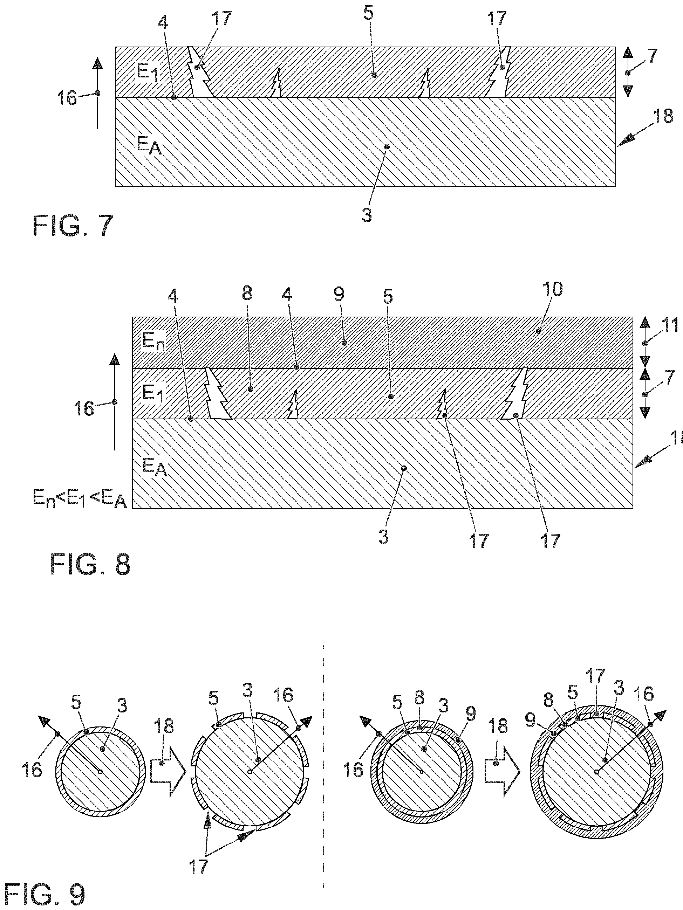

Fig. 7 zeigt ein Schichtversagen bei Volumenänderung 18 des Aktivmaterials 3 bzw. des Aktivmaterialkörpers 1 nach Fig. 2. Auf die Ausführungen zu Fig. 2 wird verwiesen.

Die Risse 17 entstehen an der Oberfläche 4 des Aktivmaterials 3 und breiten sich in der ersten Beschichtung 5 entlang der radialen Richtung 16 nach außen aus.

Fig. 8 zeigt eine Rissausbreitung bei dem Aktivmaterialkörper 1 nach Fig. 3. Auf die Ausführungen zu Fig. 7 und Fig. 3 wird verwiesen.

Hier wird dargestellt, dass die Ausbreitung der Risse 17 durch die zweite Beschichtung 9 gestoppt werden kann.

Fig. 9 zeigt eine Gegenüberstellung der Aktivmaterialkörper 1 gemäß Fig. 7 und 8. Auf die Ausführungen zu Fig. 7 und 8 wird verwiesen.

Auf der linken Seite der Fig. 9 ist der Aktivmaterialkörper 1 nach Fig. 7 vor (links) und nach (rechts) der Volumenänderung 18 dargestellt. Erkennbar kann die erste Beschichtung 5 das Aktivmaterial 3 nach der Volumenänderung 18 nicht mehr vollständig abdecken.

Auf der rechten Seite der Fig. 9 ist der Aktivmaterialkörper 1 nach Fig. 8 vor (links) und nach (rechts) der Volumenänderung 18 dargestellt. Erkennbar kann die erste Beschichtung 5 das Aktivmaterial 3 nach der Volumenänderung 18 nicht mehr vollständig abdecken. Allerdings ist eine zweite Beschichtung 9 vorgesehen, die das Aktivmaterial 3 weiter abdeckt.

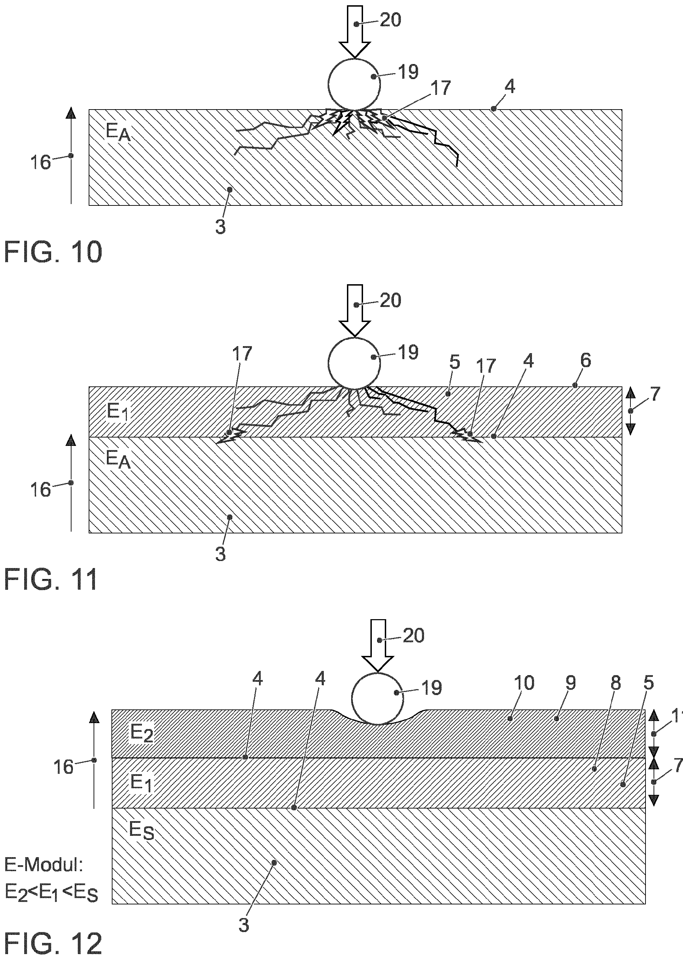

Fig. 10 zeigt eine Schädigung des Aktivmaterialkörpers 1 bei Aufbringung einer äußeren mechanischen Last bzw. Kraft 20. Dabei wird eine Kugel 19 mit einer Kraft 20 auf die Oberfläche 4 des Aktivmaterials 3 aufgebracht. Es kommt zu einer Rissbildung und Fragmentierung des Aktivmaterials 3.

Fig. 11 zeigt eine Schädigung des Aktivmaterialkörpers 1 nach Fig. 2 bei Aufbringung einer äußeren mechanischen Last bzw. Kraft 20. Auf die Ausführungen zu Fig. 2 und 10 wird verwiesen.

Die Risse 17 breiten sich durch die erste Beschichtung 5 und bis in das Aktivmaterial 3 hinein aus.

Fig. 12 zeigt eine Schädigung des Aktivmaterialkörpers 1 nach Fig. 3 bei Aufbringung einer äußeren mechanischen Last bzw. Kraft 20. Auf die Ausführungen zu Fig. 3 und 10 bzw. 11 wird verwiesen.

Die zweite Beschichtung 9 wird durch die Kugel 19 verformt. Aufgrund des geringen Elastizitätsmoduls 15 der zweiten Beschichtung 9 kommt es jedoch nur zu einer Verformung der zweiten Beschichtung 9, nicht jedoch zu einer Ausbildung von Rissen 17.

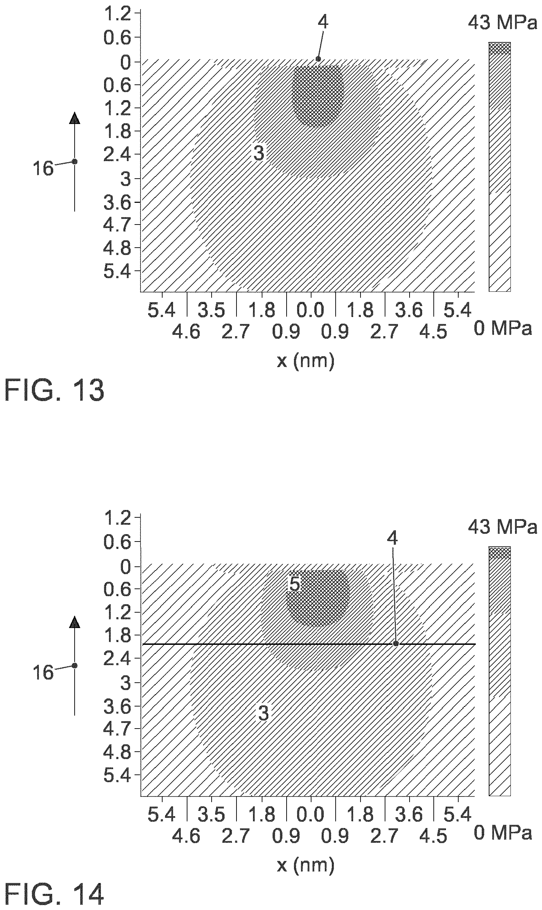

Fig. 13 zeigt eine Simulation einer mechanischen Belastung eines Aktivmaterials 3 (ohne Beschichtung). Auf der vertikalen Achse ist die radiale Richtung 16 ausgehend von der Oberfläche 4 aufgetragen. Auf der rechten Seite des Diagramms ist der Maßstab für die ermittelten Spannungen dargestellt. Auf der horizontalen Achse ist ein Weg 21 entlang des Aktivmaterialkörpers 1 (parallel zur Oberfläche 4) dargestellt.

In den Fig. 13, 14, und 15 wird jeweils eine Van-Mises Spannungsverteilung dargestellt. Der Maximalwert der Spannung beträgt in Fig. 13 43,7MPa [Megapascal] (hier im Aktivmaterial 3). Das Aktivmaterial 3 ist NMC 111. Das Elastizitätsmodul des Aktivmaterials 3 beträgt 120 GPa.

Fig. 14 zeigt eine Simulation einer mechanischen Belastung eines Aktivmaterialkörpers 1 nach Fig. 2. Auf die Ausführungen zu Fig. 13 und Fig. 2 wird verwiesen.

Erkennbar konnten die Spannungen in dem Aktivmaterial 3 (unterhalb der Linie) verringert werden.

Der Maximalwert der Spannung beträgt in Fig. 14 38,3 MPa [Megapascal] (hier in der ersten Beschichtung 5). Das Aktivmaterial 3 ist NMC 111. Das Elastizitätsmodul der ersten Beschichtung 5 beträgt 81 GPa (hier LiF).

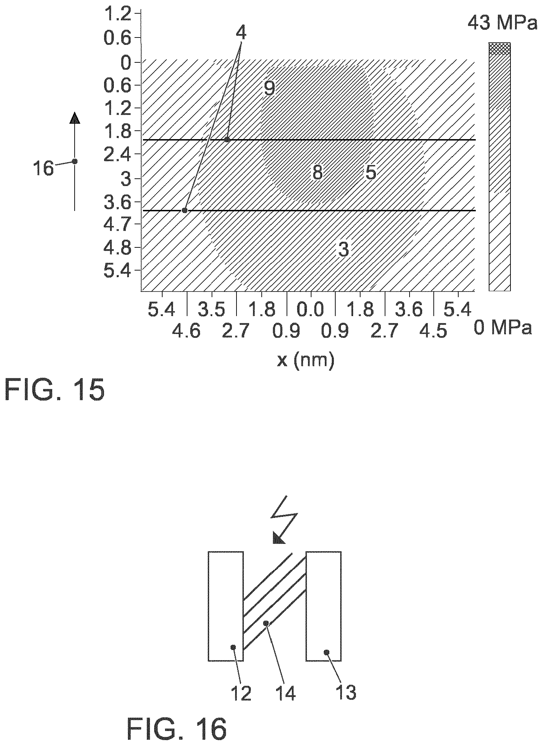

Fig. 15 zeigt eine Simulation einer mechanischen Belastung eines Aktivmaterialkörpers 1 nach Fig. 3. Auf die Ausführungen zu Fig. 13, 14 und Fig. 3 wird verwiesen.

Erkennbar konnten die Spannungen in dem Aktivmaterialkörper 1 (also auch in den Beschichtungen 5, 8, 9) verringert werden.

Der Maximalwert der Spannung beträgt in Fig. 15 19,35 MPa [Megapascal] (hier in der zweiten Beschichtung 9). Das Aktivmaterial 3 ist NMC 111. Das Elastizitätsmodul der ersten Beschichtung 5 beträgt 81 GPa (hier LiF). Das Elastizitätsmodul der zweiten Beschichtung 9 beträgt 20 GPa (hier Polymer).

Fig. 16 zeigt einen Akkumulator 2 mit einer negativ gepolten ersten Elektrode 12, einer positiv gepolten zweiten Elektrode 13 und ein die erste Elektrode 12 und die zweite Elektrode 13 ionenleitend verbindendes Elektrolyt 14.

### Bezugszeichenliste

- 1: Aktivmaterialkörper
- 2: Akkumulator
- 3: Aktivmaterial
- 4: Oberfläche
- 5: erste Beschichtung
- 6: erstes Material
- 7: erste Dicke
- 8: n-1-te Beschichtung
- 9: n-te Beschichtung
- 10: n-tes Material
- 11: n-te Dicke
- 12: erste Elektrode
- 13: zweite Elektrode
- 14: Elektrolyt
- 15: Elastizitätsmodul [GPa]
- 16: radiale Richtung
- 17: Riss
- 18: Volumenänderung
- 19: Kugel
- 20: Kraft
- 21: Weg

## Patentansprüche

1. Aktivmaterialkörper (1) für einen Akkumulator (2), wobei der Aktivmaterialkörper (1) zumindest ein Aktivmaterial (3), das ein Aktivmaterial-Elastizitätsmodul E_{A} aufweist, und mindestens eine an einer Oberfläche (4) des Aktivmaterials (3) angeordnete schichtförmige erste Beschichtung (5) umfasst, wobei die erste Beschichtung (5) aus einem ersten Material (6) mit einem ersten Elastizitätsmodul E₁ besteht; wobei gilt: erstes Elastizitätsmodul ≤ Aktivmaterial-Elastizitätsmodul; wobei der Aktivmaterialkörper (1) mindestens eine an der Oberfläche (4) einer n-1-ten Beschichtung (8) angeordnete n-te Beschichtung (9) umfasst, wobei die n-te Beschichtung (9) aus einem n-ten Material (10) mit einem n-ten Elastizitätsmodul Eₙ besteht, wobei n = 2, 3, 4, ...; wobei gilt: n-tes Elastizitätsmodul ≤ n-1-tes Elastizitätsmodul ≤ Aktivmaterial-Elastizitätsmodul.

2. Aktivmaterialkörper (1) nach Patentanspruch 1, wobei zumindest die erste Beschichtung (5) eine erste Dicke (7) von höchstens 2 Nanometern aufweist.

3. Aktivmaterialkörper (1) nach einem der vorhergehenden Patentansprüche, wobei zumindest das erste Material (6) eine anorganische Keramik ist.

4. Aktivmaterialkörper (1) nach einem der vorhergehenden Patentansprüche, wobei zumindest zwei zueinander benachbart angeordnete Beschichtungen (5, 8, 9) Elastizitätsmodule E₁, Eₙ aufweisen, die sich um mindestens 10 GPa [GigaPascal] voneinander unterscheiden.

5. Aktivmaterialkörper (1) nach einem der vorhergehenden Patentansprüche, wobei zumindest ein n-tes Material (10), mit n = 2, 3, 4,..., ein rein organisches Material oder ein anorganisches-organisches Hybridmaterial umfasst.

6. Aktivmaterialkörper (1) nach einem der vorhergehenden Patentansprüche, wobei eine n-te Beschichtung (9) eine n-te Dicke (11) aufweist, mit n = 2, 3, 4,..., wobei zumindest eine der n-ten Dicken (11) mindestens so groß ist wie eine erste Dicke (7) der ersten Beschichtung (5).

7. Aktivmaterialkörper (1) nach einem der vorhergehenden Patentansprüche, wobei zumindest die erste Beschichtung (5) durch ein chemisches Gasabscheidungsverfahren auf der Oberfläche (4) des Aktivmaterials (3) appliziert ist.

8. Aktivmaterialkörper (1) nach einem der vorhergehenden Patentansprüche, wobei das Aktivmaterial (3) Lithiumionen enthält.

9. Akkumulator (2), zumindest aufweisend eine negativ gepolte erste Elektrode (12), eine positiv gepolte zweite Elektrode (13) und ein die erste Elektrode (12) und die zweite Elektrode (13) verbindendes Elektrolyt (14), wobei zumindest eine der Elektroden (12, 13) ein Aktivmaterialkörper (1) nach einem der vorhergehenden Patentansprüche umfasst.

## Claims

1. Active material body (1) for a battery (2), wherein the active material body (1) has at least one active material (3) which has an active-material modulus of elasticity E_{A}, and at least one layered first coating (5) arranged on a surface (4) of the active material (3), wherein the first coating (5) consists of a first material (6) having a first modulus of elasticity E₁; wherein the following applies: the first modulus of elasticity ≤ active-material modulus of elasticity; wherein the active material body (1) comprises at least one nth coating (9) arranged on the surface (4) of an (n-1)th coating (8), wherein the nth coating (9) consists of an nth material (10) having an nth modulus of elasticity Eₙ, wherein n = 2, 3, 4, ...; wherein the following applies: the nth modulus of elasticity ≤ (n-1)th modulus of elasticity ≤ active-material modulus of elasticity.

2. Active material body (1) according to Claim 1, wherein at least the first coating (5) has a first thickness (7) of at most 2 nanometers.

3. Active material body (1) according to either of the preceding claims, wherein at least the first material (6) is an inorganic ceramic.

4. Active material body (1) according to any one of the preceding claims, wherein at least two coatings (5, 8, 9) arranged adjacent to one another have moduli of elasticity E₁, Eₙ that differ from one another by at least 10 GPa [gigapascal].

5. Active material body (1) according to any one of the preceding claims, wherein at least one nth material (10), where n = 2, 3, 4, ..., comprises a purely organic material or an inorganic-organic hybrid material.

6. Active material body (1) according to any one of the preceding claims, wherein an nth coating (9) has an nth thickness (11), where n = 2, 3, 4, ..., wherein at least one of the nth thicknesses (11) is at least as large as a first thickness (7) of the first coating (5).

7. Active material body (1) according to any one of the preceding claims, wherein at least the first coating (5) is applied to the surface (4) of the active material (3) by a chemical gas deposition process.

8. Active material body (1) according to any one of the preceding claims, wherein the active material (3) contains lithium ions.

9. Battery (2) having at least a negatively poled first electrode (12), a positively poled second electrode (13) and an electrolyte (14) connecting the first electrode (12) and the second electrode (13), wherein at least one of the electrodes (12, 13) comprises an active material body (1) according to any one of the preceding claims.

## Revendications

1. Corps de matière active (1) pour un accumulateur (2), dans lequel le corps de matière active (1) comprend au moins une matière active (3), qui présente un module d'élasticité de matière active E_{A} et au moins un premier revêtement (5) en forme de couche disposé sur une surface (4) de la matière active (3), dans lequel le premier revêtement (5) est constitué d'une première matière (6) avec un premier module d'élasticité E₁ ; dans lequel s'applique : premier module d'élasticité ≤ module d'élasticité de matière active ; dans lequel le corps de matière active (1) comprend au moins un n-ème revêtement (9) disposé sur la surface (4) d'un n-1-ème revêtement (8), dans lequel le n-ème revêtement (9) est constitué d'une n-ème matière (10) avec un n-ème module d'élasticité Eₙ, dans lequel n = 2, 3, 4,... ; dans lequel s'applique : n-ème module d'élasticité ≤ n-1-ème module d'élasticité ≤ module d'élasticité de matière active.

2. Corps de matière active (1) selon la revendication 1, dans lequel au moins le premier revêtement (5) présente une première épaisseur (7) d'au plus 2 nanomètres.

3. Corps de matière active (1) selon l'une quelconque des revendications précédentes, dans lequel au moins la première matière (6) est une céramique inorganique.

4. Corps de matière active (1) selon l'une quelconque des revendications précédentes, dans lequel au moins deux revêtements (5, 8, 9) disposés adjacents l'un à l'autre présentent des modules d'élasticité E₁, Eₙ, qui diffèrent les uns des autres d'au moins 10 GPa [GigaPascal].

5. Corps de matière active (1) selon l'une quelconque des revendications précédentes, dans lequel au moins une n-ème matière (10), avec n = 2, 3, 4,..., comprend une matière organique pure ou une matière hybride inorganiqueorganique.

6. Corps de matière active (1) selon l'une quelconque des revendications précédentes, dans lequel un n-ème revêtement (9) présente une n-ème épaisseur (11), avec n = 2, 3,4,..., dans lequel au moins une des n-èmes épaisseurs (11) est au moins aussi grande qu'une première épaisseur (7) du premier revêtement (5).

7. Corps de matière active (1) selon l'une quelconque des revendications précédentes, dans lequel au moins le premier revêtement (5) est appliqué par un procédé de dépôt chimique en phase vapeur sur la surface (4) de la matière active (3).

8. Corps de matière active (1) selon l'une quelconque des revendications précédentes, dans lequel la matière active (3) contient des ions de lithium.

9. Accumulateur (2), présentant au moins une première électrode à pôle négatif (12), une seconde électrode à pôle positif (13) et un électrolyte (14) reliant la première électrode (12) et la seconde électrode (13), dans lequel au moins une des électrodes (12, 13) comprend un corps de matière active (1) selon l'une quelconque des revendications précédentes.
